Europäisches Patentamt

European Patent Office

Office européen des brevets

(11) Veröffentlichungsnummer: **0 578 906 A2**

## (12) EUROPÄISCHE PATENTANMELDUNG

(21) Anmeldenummer: **93100544.1**

(22) Anmeldetag: **15.01.93**

(51) Int. Cl.5: **G01R 27/26**

(30) Priorität: **11.07.92 DE 4222930**

(43) Veröffentlichungstag der Anmeldung:
**19.01.94 Patentblatt 94/03**

(84) Benannte Vertragsstaaten:
**DE FR GB**

(71) Anmelder: **VDO Adolf Schindling AG**
**Gräfstrasse 103**
**D-60487 Frankfurt(DE)**

(72) Erfinder: **Kern, Wolfram**
**Luxemburger Strasse 46**
**O-3027 Magdeburg(DE)**

(74) Vertreter: **Klein, Thomas, Dipl.-Ing. (FH)**
**Sodener Strasse 9**
**D-65824 Schwalbach/Ts. (DE)**

(54) **Schaltungsanordnung zur Messung von Kapazitäten.**

(57) Bei einer Schaltungsanordnung für einen Sensor, insbesondere für einen Drucksensor, mit einem Kondensator, dessen Kapazität von einer zu messenden physikalischen Größe im wesentlichen umgekehrt proportional abhängt, ist eine Wechselspannung über einen weiteren Kondensator einem invertierenden Eingang eines Verstärkers zuführbar, dessen Ausgang über den Kondensator mit dem invertierenden Eingang verbunden ist. An den Ausgang des Verstärkers ist eine Auswerteschaltung angeschlossen.

Fig. 1

EP 0 578 906 A2

Die Erfindung betrifft eine Schaltungsanordnung für einen Sensor, insbesondere für einen Drucksensor, mit einem Kondensator, dessen Kapazität von einer zu messenden physikalischen Größe im wesentlichen umgekehrt proportional abhängt.

Aufgabe der vorliegenden Erfindung ist es, eine Schaltungsanordnung anzugeben, welche in vorteilhafter Weise die Ableitung einer Spannung ermöglicht, die weitgehend proportional zu der zu messenden physikalischen Größe ist - insbesondere zum Druck, einer Flüssigkeit oder eines anderen Mediums.

Die erfindungsgemäße Schaltungsanordnung ist dadurch gekennzeichnet, daß eine Wechselspannung über einen weiteren Kondensator einem invertierenden Eingang eines Verstärkers zuführbar ist, dessen Ausgang über den Kondensator mit dem invertierenden Eingang verbunden ist und daß an den Ausgang des Verstärkers eine Auswerteschaltung angeschlossen ist.

Mit der erfindungsgemäßen Schaltungsanordnung wird in einfacher Weise eine zur zu messenden Größe proportionale Spannung abgeleitet, obwohl die Kapazität des Kondensators umgekehrt proportional zur Größe ist. Außerdem hat die erfindungsgemäße Schaltungsanordnung den Vorteil, daß parasitäre Kapazitäten unterdrückt werden, die zwischen den Zuleitungen des Sensorkondensators und Massepotential wirken. Diese Unterdrückung erfolgt im Falle der einen Zuleitung dadurch, daß die Spannung am Eingang des Verstärkers auf einem nahezu konstanten Potential gehalten wird und somit die Umladung des Sensorkondensators nicht beeinflussen kann. Im Falle der anderen Zuleitung verhindert ein niedriger Ausgangswiderstand des Verstärkers einen Einfluß der parasitären Kapazität.

Eine Weiterbildung der Erfindung besteht darin, daß der weitere Kondensator als Kompensationskondensator dient und in wärmeleitender Verbindung mit dem Kondensator steht. Hierdurch wird in einfacher Weise eine Kompensation der Temperaturabhängigkeit der Kapazität des Kondensators ermöglicht.

Eine besonders einfache Ausbildung der Schaltungsanordnung und eine gute Amplitudenkonstanz der Wechselspannung werden erreicht, wenn die Wechselspannung rechteckförmig ist.

Zur Erzeugung der rechteckförmigen Wechselspannung ist bei einer Ausführungsform dieser Weiterbildung ein Oszillator vorgesehen, der einen steuerbaren Umschalter derart steuert, daß dem weiteren Kondensator abwechselnd zwei verschiedene dem Umschalter zugeführte Potentiale zugeführt werden.

Eine andere vorteilhafte Weiterbildung der erfindungsgemäßen Schaltungsanordnung besteht darin, daß die Auswerteschaltung eine Gleichrichterschaltung und einen nachgeschalteten Tiefpaß enthält. Dabei ist die Gleichrichterschaltung vorzugsweise als Synchrondemodultaor ausgebildet.

Eine vorteilhafte Ausführungsform dieser Weiterbildung besteht darin, daß der Synchrondemodulator von einem weiteren Umschalter gebildet ist, der vom Oszillator gesteuert wird, dessen einer Eingang über einen dritten Kondensator mit dem Ausgang des invertierenden Verstärkers und mit dem Eingang eines weiteren invertierenden Verstärkers verbunden ist, dessen Ausgang an einen weiteren Eingang des weiteren Umschalters angeschlossen ist, und daß ein Ausgang des weiteren Umschalters mit dem Eingang eines Tiefpasses verbunden ist.

Die Erfindung läßt zahlreiche Ausführungsformen zu. Mehrere davon sind schematisch in der Zeichnung anhand mehrerer Figuren dargestellt und nachfolgend beschrieben. Es zeigt:

Fig. 1        ein Prinzipschaltbild einer erfindungsgemäßen Schaltungsanordnung,
Fig. 2        ein Ausführungsbeispiel,
Fig. 3        ein zweites Ausführungsbeispiel in detaillierterer Darstellung und
Fig. 4        ein drittes Ausführungsbeispiel.

Gleiche Teile sind in den Figuren mit gleichen Bezugszeichen versehen.

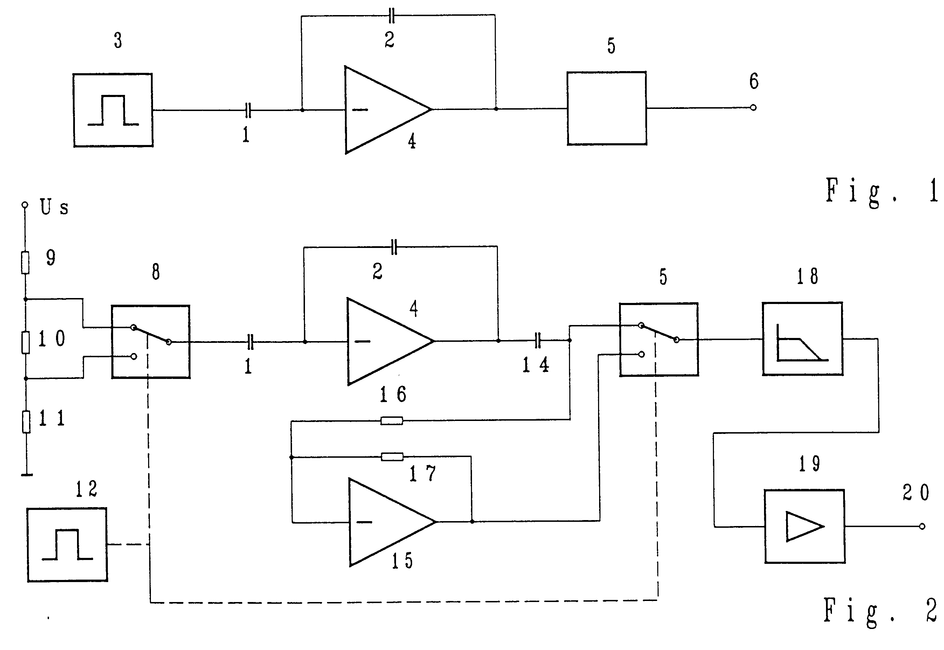

Bei der Schaltungsanordnung nach Fig. 1 ist ein erster Kondensator 1 zwischen den Ausgang eines Oszillators 3 und den Eingang eines invertierenden Verstärkers 4 geschaltet. Der Ausgang des invertierenden Verstärkers 4 ist über einen zweiten Kondensator 2 mit dem Eingang verbunden. Ferner ist der Ausgang des invertierenden Verstärkers 4 mit dem Eingang einer Auswerteschaltung 5 verbunden, deren Ausgang den Ausgang 6 der Schaltungsanordnung bildet.

Die Spannung am Ausgang 6 ergibt sich zu $U_a = f(C_1/C_2)$. Dabei ist f eine im wesentlichen lineare Funktion. $C_1$ ist die Kapazität des ersten Kondensators 1, während $C_2$ die Kapazität des zweiten Kondensators 2 ist. Bei der bevorzugten Anwendung der Schaltungsanordnung ist der zweite Kondensator (2) Teil eines Drucksensors und wird im folgenden Sensorkondensator genannt. Seine Kapazität ist umgekehrt proportional zum zu messenden Druck. Der erste Kondensator dient zur Kompensation der Temperaturabhängigkeit der Kapazität des zweiten Kondensators und steht in wärmeleitender Verbindung zum Sensorkondensator.

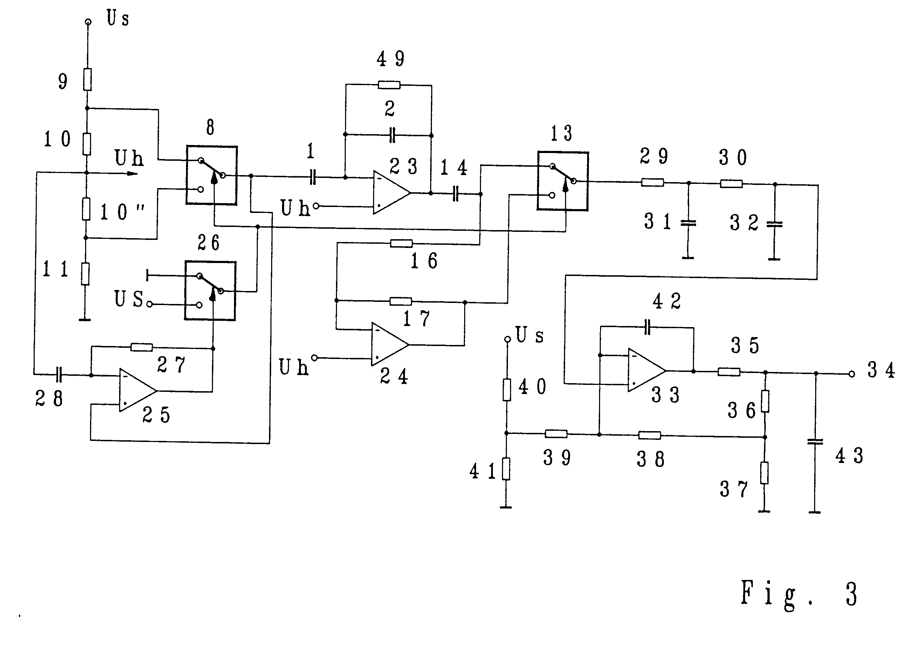

Bei dem Ausführungsbeispiel nach Fig. 2 wird die Wechselspannung dadurch erzeugt, daß ein steuerbarer Umschalter 8 den Kompensationskondensator 1 abwechselnd mit zwei Abgriffen eines Spannungsteilers 9, 10, 11 verbindet, der mit einer konstanten Spannung $U_S$ beaufschlagt ist. Zur Steuerung des Umschalters dient ein Rechteck-Oszillator 12.

Das Verhältnis der Kapazitäten $C_1$ zu $C_2$ bewirkt eine Amplitudenmodulation der Wechselspannung. Zur Demodulation dient ein Synchrondemodulator, der einen weiteren Umschalter 13 umfaßt, der ebenfalls vom Rechteck-Oszillator 12 gesteuert wird. Diesem Umschalter wird über einen dritten Kondensator 14 die Ausgangsspannung einerseits direkt und über einen weiteren invertierenden Verstärker 15 in invertierter Form zugeführt. Der weitere invertierende Verstärker 15 ist mit Widerständen 16, 17 derart beschaltet, daß der Verstärkungsgrad -1 beträgt.

Durch die Wirkung des weiteren Umschalters 13 wird die Polarität jeder zweiten Halbwelle umgekehrt, so daß eine Amplitudendemodulation entsteht. Das demodulierte Signal wird über einen Tiefpaß 18 und einen Verstärker 19 zum Ausgang 20 geleitet.

Bei dem Ausführungsbeispiel nach Fig. 3 sind die invertierenden Verstärker als Differenzverstärker 23, 24 ausgebildet, deren nichtinvertierende Eingänge eine Vorspannung $U_H$ von einer weiteren Anzapfung 22 des Spannungsteilers 9, 10', 10'', 11 erhalten. Aus Symmetriegründen ist die Vorspannung $U_H$ derart gewählt, daß sie in der Mitte zwischen den Spannungen liegt, welche dem Umschalter 8 zugeführt werden. Als Rechteck-Oszillator dient ein weiterer Differenzverstärker 25, der über einen weiteren Umschalter 26 und den Umschalter 8 rückgekoppelt ist. Außerdem ist der Differenzverstärker über einen Widerstand 27 gegengekoppelt und der invertierende Eingang über einen Kondensator 28 mit der Anzapfung 22 des Spannungsteilers 9 bis 11 verbunden.

Bei dem Ausführungsbeispiel nach Fig. 3 ist dem Kondensator 2 ein Gegenkopplungswiderstand 49 parallelgeschaltet. Der an den Umschalter 13 angeschlossene Tiefpaß wird von zwei Widerständen 29, 30 und zwei Kondensatoren 31, 32 gebildet. Ein weiterer Differenzverstärker 33 ist in an sich bekannter Weise mit einem Netzwerk aus mehreren Widerständen 35 bis 41 und einem Kondensator beschaltet, die zur frequenzabhängigen Gegenkopplung und zur Festlegung des Arbeitspunktes dienen. Der Differenzverstärker 33 führt ein verstärktes demoduliertes Signal zum Ausgang 34 der Schaltungsanordnung, der zur Vermeidung von Störspitzen über einen Kondensator 43 mit Masse verbunden ist.

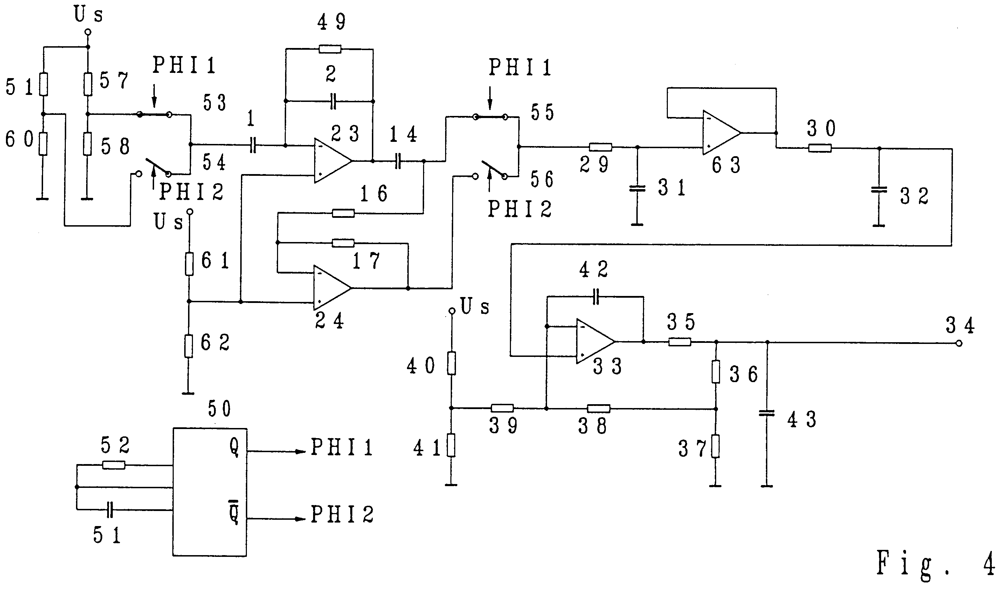

Bei dem Ausführungsbeispiel nach Fig. 4 ist der Rechteck-Oszillator mit Hilfe eines integrierten Schaltkreises 50 vom Typ 4047 aufgebaut, dem als frequenzbestimmendes Glied ein Kondensator 51 und ein Widerstand 52 zugeordnet sind. Die steuerbaren Umschalter werden bei dem Ausführungsbeispiel nach Fig. 4 von jeweils zwei Schaltern 53, 54 bzw. 55, 56 gebildet, von denen jeweils mehrere in einem integrierten Schaltkreis erhältlich sind. Die Schalter 53 und 55 werden vom Ausgangssignal $\Phi_1$ und die Schalter 54 und 56 von dem Ausgangssignal $\Phi_2$ des Rechteck-Oszillators angesteuert. Für die die Wechselspannung bildenden Spannungen ist jeweils ein Spannungsteiler 57, 58 bzw. 59, 60 vorgesehen. Auch die den nichtinvertierenden Eingängen der Differenzverstärker 23, 24 zugeführte Spannung wird einem separaten Spannungsteiler 61, 62 entnommen.

Bei der Schaltungsanordnung nach Fig. 4 ist zwischen dem ersten Glied 29, 31 und dem zweiten Glied 30, 32 des Tiefpasses ein als Impedanzwandler geschalteter Differenzverstärker 63 angeordnet. Die übrigen Teile der Schaltungsanordnung nach Fig. 4 entsprechen denen der Schaltungsanordnung nach Fig. 3.

Eine vorteilhafte Dimensionierung der Schaltungsanordnung nach Fig. 4 ist im folgenden angegeben:

| | | | |
|---|---|---|---|
| $C_1 = 27pF$ | $C_2 \approx 27pF$ | $C_{14} = 100nF$ | $C_{31} = 10nF$ |
| $C_{32} = 10nF$ | $C_{42} = 220pF$ | $C_{43} = 100nF$ | |
| $R_{16} = 10k\Omega$ | $R_{17} = 10k\Omega$ | $R_{29} = 100k\Omega$ | $R_{30} = 100k\Omega$ |
| $R_{35} = 100k\Omega$ | $R_{36} = 30k\Omega$ | $R_{37} = 2k\Omega$ | $R_{38} = 100k\Omega$ |
| $R_{39} = 100k\Omega$ | $R_{40} = 18k\Omega$ | $R_{41} = 4,94k\Omega$ | $R_{49} = 10M\Omega$ |
| $R_{57} = 4k\Omega$ | $R_{58} = 6k\Omega$ | $R_{59} = 9k\Omega$ | $R_{60} = 1k\Omega$ |
| $R_{61} = 12,8k\Omega$ | $R_{62} = 6,2k\Omega$ | | |

Als Frequenz $f_{OSZ}$ hat sich ein Wert von etwa 4,8kHz als günstig herausgestellt, der mit $C_{51} = 3,3nF$ und $R_{52} = 13,3k\Omega$ erreicht wird.

**Patentansprüche**

1. Schaltungsanordnung für einen Sensor, insbesondere für einen Drucksensor, mit einem Kondensator, dessen Kapazität von einer zu messenden physikalischen Größe im wesentlichen umgekehrt proportional abhängt, dadurch gekennzeichnet, daß eine Wechselspannung über einen weiteren Kondensator (1) einem invertierenden Eingang eines Verstärkers (4, 23) zuführbar ist, dessen Ausgang über den Kondensator (2) mit dem invertierenden Eingang verbunden ist und daß an den Ausgang des Verstärkers eine Auswerteschaltung (5) angeschlossen ist.

**2.** Schaltungsanordnung nach Anspruch 1, dadurch gekennzeichnet, daß der weitere Kondensator (1) als Kompensationskondensator dient und in wärmeleitender Verbindung mit dem Kondensator (2) steht.

**3.** Schaltungsanordnung nach einem der Ansprüche 1 oder 2, dadurch gekennzeichnet, daß die Wechselspannung rechteckförmig ist.

**4.** Schaltungsanordnung nach Anspruch 3, dadurch gekennzeichnet, daß ein Oszillator (12, 25, 50) vorgesehen ist, der einen steuerbaren Umschalter (8; 53, 54) derart steuert, daß dem weiteren Kondensator (1) abwechselnd zwei verschiedene dem Umschalter (8, 53, 54) zugeführte Potentiale zugeführt werden.

**5.** Schaltungsanordnung nach einem der vorhergehenden Ansprüche, dadurch gekennzeichnet, daß die Auswerteschaltung eine Gleichrichterschaltung (13, 15, 16, 17; 13, 16, 17, 24) und einen nachgeschalteten Tiefpaß (29 bis 32) enthält.

**6.** Schaltungsanordnung nach Anspruch 5, dadurch gekennzeichnet, daß die Gleichrichterschaltung als Synchrondemodulator ausgebildet ist.

**7.** Schaltungsanordnung nach Anspruch 6, dadurch gekennzeichnet, daß der Synchrondemodulator von einem weiteren Umschalter (13; 55, 56) gebildet ist, der vom Oszillator (12, 25, 50) gesteuert wird, dessen einer Eingang über einen dritten Kondensator (14) mit dem Ausgang des invertierenden Verstärkers (4, 23) und mit dem Eingang eines weiteren invertierenden Verstärkers (15, 24) verbunden ist, dessen Ausgang an einen weiteren Eingang des weiteren Umschalters (13; 55, 56) angeschlossen ist, und daß ein Ausgang des weiteren Umschalters mit dem Eingang eines Tiefpasses (29 bis 32) verbunden ist.

4

Fig. 1

Fig. 2

EP 0 578 906 A2

Fig. 3

Fig. 4